(19) Europäisches Patentamt
European Patent Office
Office européen des brevets

(11) **EP 4 760 329 A1**

(12) **EUROPEAN PATENT APPLICATION**

(43) Date of publication:
**17.06.2026 Bulletin 2026/25**

(21) Application number: **24218587.4**

(22) Date of filing: **10.12.2024**

(51) International Patent Classification (IPC):
**G01R 33/54** $^{(2006.01)}$    **G06T 11/00** $^{(2026.01)}$

(52) Cooperative Patent Classification (CPC):
**G01R 33/54; G01R 33/583; G06T 11/00**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Friedrich-Alexander-Universität Erlangen-Nürnberg,**
**in Vertretung des Freistaates Bayern**
**91054 Erlangen (DE)**

(72) Inventors:
• **Endres, Jonathan**
  **91054 Erlangen (DE)**
• **Weinmüller, Simon**
  **91054 Erlangen (DE)**
• **Zaiß, Moritz**
  **91054 Erlangen (DE)**
• **Dörfler, Arnd**
  **91054 Erlangen (DE)**

(74) Representative: **Fink Numrich**
**Patentanwälte PartmbB**
**Paul-Gerhardt-Allee 24**
**81245 München (DE)**

(54) **METHOD AND APPARATUS FOR COMPUTER-IMPLEMENTED PROCESSING OF MR SEQUENCES**

(57)    The invention describes a method for computer-implemented processing of MR sequences based on a Bloch-simulation. The method comprises the steps of:

a) providing a parameter set to be processed by the Bloch-simulation for an object to be simulated, where the parameter set comprises at least one of 3D parameter maps of proton density (PD), $T_1$, $T_2$, and $T_2'$ relaxation times, field inhomogeneity maps of $B_0$ and $B_1$, and isotropic or anisotropic diffusion parametrization;

b) conducting an MRI simulation by executing the Bloch-simulation using the provided parameter set in order to calculate a signal response of MR sequences, where conducting the MRI simulation consists of processing a description of Bloch-equations in the Fourier domain, where phase distribution graphs, PDGs, describing a magnetization at any point during an MR sequence are processed;

c) processing the signal response to provide reconstruction information; and

d) deriving target data from the reconstruction information, the target data comprising a contrast information.

Calculating the signal response ($S^+$) comprises integrating of the transversal (+) magnetization over space and frequence spectrum. The magnetization of a spin at a position $r$ with a Larmor frequency of $\omega$ is determined for all simulated voxels $v$ by directly using the density of a tissue as a distribution $V(r)$ describing the magnetization density inside a voxel segment.

Fig. 1

Gradient descent / Backpropagation

**Description**

The present invention relates to a method and a data processing apparatus for computer-implemented processing of MR (Magnetic Resonance) sequences based on a differentiable Bloch-simulation. The present invention further relates to a computer-program product.

Bloch simulations are an indispensable tool for testing, analyzing and optimizing MR sequences. By executing the Bloch equations for a large number of spatial spin samples, so-called isochromats, in a digital phantom, it is possible to calculate a signal response one would get when measuring an MR sequence on a real system, dependent on the properties of the measured tissue and the flip angles, gradients, and timing of the sequence. Within the Bloch equations, $T_1$ and $T_2$ relaxation can be modeled, as well as $T_2'$ effects with intra-voxel frequency distributions. Moreover, diffusion and macroscopic motion processes can be modeled. Bloch simulations can be used to analyze the evolution of magnetization, as well as to optimize the sequence, including gradient and RF pulse shapes.

One drawback of Bloch simulations is that the duration of the simulation is too long in order to be able to carry out the simulation for an object to be examined.

An alternative for using isochromats is given by the well-known extended phase graph (EPG) formalism. EPG is an analytical description of the Bloch equations in the Fourier domain and handles spatial frequencies exactly instead of approximating it with many isochromats. EPG splits the magnetization into multiple parts or states with different dephasing, which makes it possible to reason about the timing of echoes and the different magnetization pathways contributing to the signal. When using EPG to simulate MR sequences, typically a tensor of states is used, where various operators can exchange the population between states or tensor indices, but cannot create new indices or change the dephasing that is described by a single index. This method is known as state-tensor-EPG (ST-EPG) to distinguish between EPG in general.

Because ST-EPGs sample k-space on an equidistant grid and don't support arbitrary dephasing for a single simulation step, they are only used to simulate periodic sequences with an identical amount of dephasing between any pair of subsequent RF pulses, usually sampling the echo tops of the signal. They don't support simulating $T_2'$ decay separately from arbitrary gradients or varying RF pulse timing. Until now, the application of ST-EPG is limited to simulate and optimize the signal course of highly regular sequences and cannot be used as a full replacement for isochromat-based Bloch simulations. Without quantitative gradient dephasing description, ST-EPG simulations don't produce an encoded signal that could be reconstructed into an image.

Based on the EPG concept, an algorithm labeled phase distribution graphs (PDG), has been developed which lifts the limitations of ST-EPG, making it a drop-in replacement for isochromat-based simulations. PDGs describe the magnetization at any point during the sequence by splitting it into a variable number of states, each representing a part of the magnetization with arbitrary gradient and time dephasing. This allows to calculate measurement sample values for MR sequences with any timing, k-space readout trajectories, spoiling and flip angle patterns, while still preserving the advantages of ST-EPG, such as fast computation times, noise free analytical outputs, and information about magnetization pathways. Furthermore, PDGs contain the exact dephasing and thus encoding of all parts of the magnetization, describing complete echo shapes, while being fully differentiable in time, gradients and RF pulse flip angle and phase, allowing for efficient sequence optimization.

PDG yields identical results to isochromat-based simulation while outperforming them by at least one order of magnitude, without introducing any of the Monte-Carlo noise found in isochromat-based approaches. It could be demonstrated that PDG allows full simulation and end-to-end optimization of MR sequences and provides insights into the MRI signal contributions. Details describing the concept of PDGs are given in [1].

Although a PDG simulation already outperforms isochromat-based solutions in terms of speed with typical factors of 200x and precision, there is still a need for further speedup of the simulation. In particular, it would be desirable to be able to conduct a simulation within seconds compared to hours and days as in the past.

It is therefore an object of the present invention to provide a method and an apparatus for efficient physics-based MR sequence simulation, optimization and parameter reconstruction which is significantly improved in terms of speed.

These objects are solved by a method according to the features of claim 1, a computer program product according to the features of claims 10 and an apparatus according to the features of claim 11. Preferred embodiments are set out in the dependent claims.

According to a first aspect of the present invention, a method for computer-implemented processing of MR sequences based on a Bloch-simulation. In a preferred embodiment, processing of MR sequences is based on a differentiable Bloch-simulation. In step a), a parameter set to be processed by the Bloch-simulation for an object to be simulated is provided. The parameter set comprises at least one of 3D parameter maps of proton density (PD), $T_1$, $T_2$, and $T_2'$ relaxation times, field inhomogeneity maps of $B_0$ and $B_1$, and isotropic or anisotropic diffusion parametrization. In step b), an MRI simulation is conducted by executing the Bloch-simulation using the provided parameter set in order to calculate a signal response of MR sequences. The MR sequences are of sequential nature, thus a signal and a magnetization state at any time depends in principle on the full magnetization and sequence history. Conducting the MRI simulation consists of processing a description of Bloch-equations in the Fourier domain, where phase distribution graphs, PDGs, describing a magnetization at any point during an MR sequence are processed. This may be done by splitting it into a variable number of states, each representing a part of the magnetization with arbitrary gradient and time dephasing thereby encoding all parts of the magnetization, describing complete echo shapes, while being fully in time, gradients and RF pulse flip angle and phase, allowing for efficient sequence optimization. In a step c), the signal response is processed to provide reconstruction information. In a last step d), target data are derived from the reconstruction information, the target data comprising a contrast information. Calculating the signal response in step b) comprises integrating of the transversal magnetization over space and frequency spectrum, wherein the magnetization of a spin at a position r with a Larmor frequency of $\omega$ is determined for all simulated voxels $v$ by directly using the density of a tissue as a distribution $V(r)$ describing the magnetization density inside a voxel segment.

According to the invention, Phase Distribution Graph (PDG) simulation (as described in [1]) is combined with further strategies for the most efficient computation for both a forward and a backward process. The underlying (PDG) simulation already outperforms isochromat-based solutions in terms of speed (with typical factors of 200x) and precision. The proposed method is aiming to drive this advantage even further to enable completely new applications, such as real-time simulations prior to an examination of an object. The resulting speedup is expected to be 10.000 to 100.000, which means optimizations that previously took days are then possible within seconds.

The method according to the invention extends PDG as described above by two specific acceleration strategies, specific to the PDG formalism that are a spatial segmentation with smart filters, and optionally, a temporal segmentation with smart overlap. It is to be noted that the temporal segmentation with smart overlap is to be regarded as preferred embodiment, but not as a mandatory feature of the described method.

As described in [1], PDG is a two-pass approach where the number of computations is minimized by using a pre-pass for an approximating signal estimation, evaluating which calculations are necessary for an accurate simulation of the signal done in the second, "main-pass". However, it is to be noted that the pre-pass is not necessary for describing spatial or temporal segmentation.

This is based on the consideration that a specific problem of the simulation process is memory efficiency. As more memory is needed to process more voxels or longer sequences, this compromises resolution scaling.

1. Spatial segmentation with smart filters: Instead of simulating every single voxel, segments of voxels with nearly identical properties are built. Thus, the simulation can be accelerated from being proportional to the number of voxels, to the number of segments. Applying inhomogeneity maps as additional filters, further reduces the number of required segments which together results in an acceleration of up to 10.000 depending on the resolution and system.

2. Temporal segmentation with smart overlap: Instead of simulating the full sequence, the sequence is divided in multiple segments that can be calculated in parallel. This accelerates by parallelization, but also shortens the depth of the phase graph, which is especially relaxing for the memory demand. This division is per se not possible and requires a smart overlap of sequence segments as described below.

According to a preferred embodiment, referring to the spatial segmentation with smart overlap, the signal response ($S^+$) is calculated by

$$S^+ = \sum_{s}\sum_{k,\tau}\left(F_{k,\tau}^+\right)_s \cdot \left(e^{i\Delta\omega_0\tau} \cdot e^{-|\tau|/T_2'}\right) \cdot \tilde{V}(k)$$

wherein s is a voxel segment representing tissue, k is the modulation from $B_0$ field gradients, $\tau$ describes the width of the phase distribution as a result of off-resonance, $F_{k,\tau}$ denotes a state amplitude, $\Delta\omega_0$ is a center frequency of a Cauchy function, $T_2'$ denotes spatially varying dephasing, and $\tilde{V}(k)$ denotes a lookup of a pre-computed k-space (Fourier Transformation) of a tissue density function.

A respective voxel segment (representing a respective tissue) may have an arbitrary shape. According to a preferred embodiment, the state amplitude, $F_{k,\tau}$, and the center frequency, $\Delta\omega_0$, are assumed to be scalars, where $T_1$ and $T_2$ relaxations as well as diffusion affects the state amplitude, $F_{k,\tau}$, as does the amplitude of the RF-field $B_1$. While for the former, $T_1$ and $T_2$ relaxations, it can be assumed that they are constant within a voxel segment (as the segmentation works on areas of identical physical properties), this is not true for the latter, i.e., the RF-field $B_1$ or the off-resonance $\Delta\omega_0$.

Voxels with similar MR parameters can thus be combined into segments, which can then be used for more efficient calculation, as well as a segmentation-tailored state-selection in the PDG, which leads to additional acceleration of the simulation. Moreover, using a folding operation as described below, another non-trivial acceleration is achieved by reducing the number of different segments, as the $B_0$ and $B_1$ inhomogeneity segmentation criteria is removed. According to this preferred embodiment, referring to the spatial segmentation with smart overlap, the spatially resolved tensors, $\left(F_{k,\tau}^+\right)_{s,v}$ and $(\Delta\omega_0)_v$ are combined with the pre-computed k-space, replacing the integral over space with a folding operation in k-space according to:

$$S^+ = \sum_s \sum_{k,\tau} e^{-|\tau|/T_2'} \cdot \left(\mathcal{F}_v\left[\left(F_{k,\tau}^+\right)_{s,v} \cdot e^{i(\Delta\omega_0)_v\tau}\right] * \tilde{V}\right)(k)$$

wherein $\mathcal{F}_x\,[f(x)](y)$ denotes the Fourier Transformation of $f(x)$ over parameter $x$, evaluated at $y$. This can reduce the signal equation from a sum over all voxels to a computationally cheap, resolution independent signal calculation.

According to a further preferred embodiment, referring to the temporal segmentation with smart overlap, the MR sequence, which is the input for the Bloch-simulation, is divided into a plurality of subsegments, each subsegment having a duration of larger than $N_{T1}$-times of $T_1$ relaxation and containing sequential MR sequences, where the subsegments within the total number of MR sequences are chosen such that each adjacent two subsegments overlap the last N-times of $T_1$ relaxation. $N_{T1}$ is the overlap $T_1$ factor, which needs to be defined. A save number of N is 5, but smaller numbers are possible, depending on the sequence type. This specific embodiment deals with the length of sequences, the resulting growth of the phase distribution graphs, and vanishing gradients. MR sequences as such are of sequential nature, thus the signal and the magnetization state at any time depends in principle on the full magnetization and sequence history. This is why it is often assumed that general temporal parallelization of MR sequences is impossible.

The proposed embodiment is based on the consideration that information in the Bloch system ultimately decays with the $T_1$ and $T_2$ relaxation, with $T_1$ being typically the slowest process with values up to 4s in liquids. This directly means that any magnetization history decays by exp(-t/$T_1$), which means the information is typically decayed after 3-5 $T_1$. Thus, any sequence that is much longer than the liquid compartment $T_1$, can be divided into temporal segments of a modified structure. Instead of a single temporal segment, the MR sequence is divided into multiple segments each with the duration of larger than $N_{T1}$-times $T_1$, overlapping at the last $N_{T1}$-times $T_1$. With $N_{T1}$ needing to be determined, a save choice is 3-5.

As an advantage, the temporal subsegments are now independent and may be simulated in parallel, which breaks up the major drawback of sequential MRI simulation. The size of the subsegments may be adjusted to memory and runtime specifications of the computer system conducting the simulation. The overlap between adjacent two subsegments may be chosen identical or variable. Furthermore, the subsegments may have the same number of MR sequences or at least some of the subsegments may have a different number of MR sequences.

According to a further preferred embodiment, a two-pass simulation approach is used in which a first pre-pass of the simulation uses a fast, single voxel approximation of the magnetization and in which determined steady-states are reused during the steady-state phase simulation. The term "pre-pass" is known from PDG which is a two-pass approach where the number of computations is minimized by using a pre-pass for an approximating signal estimation. An evaluation which calculations are necessary for an accurate simulation of the signal done in the second pass called "main-pass". Details can be taken from [1]. This embodiment is based on the consideration that, in some MR sequences, certain magnetization states are driven into a steady state. This means that the magnetization state after a repetition is identical to the state before that repetition. In the pre-pass such steady-states can be detected, and the same state can be reused during the steady-state phase simulation, instead of calculating every steady-state as transient state. This significantly reduces the number of states during the graph execution and lowers the computational demand. Importantly, with PDGs the splitting of magnetization allows to avoid unnecessary re-computation of any state that was previously encountered in the sequence, even if the total magnetization is not in steady-state.

The embodiments as described above may be combined or superimposed. The method may be executed on one or more distributed CPUs, GPUs, or TPUs.

To solve the problem of fastest simulation, neural network approaches can be used. The previous embodiments allow to generate very large dictionaries, which can then be again used to train neural networks. The well-known transformer architecture can use attention layers to effectively change upon its input, thus it can learn general physics concepts allowing generalization to the MR imaging process, which is a combination of underlying in silico MR object parameters, and sequence parameters. Most similar concept is a vision transformer for image generation, or prompt-based image alteration. MR parameters form the multi-channel input image, the MR sequence forms the prompt, and the output is the MR image. Moreover, input data can in addition to the MR parameters also be at least one low accuracy or low resolution fast PDG simulation output, thus the NN/Transformer model's task is accuracy enhancement. A PDG Transformer Model that is trained with a large dictionary of 3D simulation data for many different objects and many different sequences can be used as a full simulation surrogate, with another speed gain. Moreover, it can also be used as backward model providing a starting point for optimization and iterative reconstruction.

Iterative Optimization processes can also be unrolled as shown for variational networks. For the method described above, a Model-based variational Network may be used, which consists of network layers estimating MR parameters, and data consistency checks between layers using the above-described accelerated forward simulation only. By only relying on the forward simulation, orders of magnitude of simulation speed are won and still are able to solve inverse optimization problems. A similar unrolled network can be used for sequence parameter optimization.

By having the correct forward model, both the neural network approach and the Model-based variational Network can be extended by a physics-informed data consistency, avoiding generative components in predictions and simulations.

According to a second aspect of the invention, a computer program product is proposed which comprises instructions which, when the program is executed by a computer, cause the computer to carry out the steps of the method according to one or more embodiments of the present invention.

According to a third aspect of the invention, a data processing apparatus is proposed which comprises means for carrying out the steps of the method according to one or more embodiments of the present invention.

The invention will be described more detailed with reference to the accompanying drawings.

Fig. 1          illustrates an optimization framework according to the invention based on a Bloch simulation;

Fig. 2          illustrates procedure and proof of the spatial segmentation with smart filters concept;

Fig. 3A to 3C    illustrates the principal procedure of a temporal segmentation of a sequential computation of MR sequences; and

Fig. 4          illustrates proof of the temporal segmentation concept.

PDG (described in reference [1]) is rather new, thus previous Bloch simulation approaches (as described, for example, in references [4], [5]) are based on isochromat solutions or extended phase graphs (EPG). However, PDGs predecessor, EPG (see references [2], [3]), has no image encoding, thus no full MRI simulation can be generated.

The present invention combines PDG simulation with several new strategies for most efficient computation for both the forward and the backward process as described in [1]. The underlying (PDG) simulation already outperforms isochromat-based solutions in terms of speed with typical factors of 200x at the same precision (as described in [1]). The method described hereinafter aims to drive this advantage even further to enable completely new applications. The resulting speedup is expected to be 10.000 to 100.000, which means optimizations that previously took days are then possible within seconds.

The necessary advancements over PDG with state selection include:

1. Spatial segmentation with smart filters, with exact encoding pre-pass, and multi-pre-pass approach for segmentation tailored state selection.

A specific problem in processing of MR sequences based on both a Bloch-simulation and a differentiable Bloch-simulation is memory efficiency. As more memory is needed for more voxels, this compromises resolution scaling. Instead of simulating every single voxel as is done in the method described in [1], the method according to the invention suggests building segments of voxels with nearly identical properties. Thus, the simulation can be accelerated from being proportional to the number of voxels to the number of segments. This results in an acceleration of up to 10.000 depending on the resolution and system. In the following, the invention will be described with reference to a differentiable Bloch-simulation. However, it is to be understood that the use of differentiable Bloch-simulations is not mandatory. Differentiable Bloch-simulations only have to be used in case one wants to use a gradient descent.

Moreover, the segments are already similar in their MR parameters, which can then be used for more efficient segmentation-tailored state-selection in the PDG, which leads to additional non-trivial acceleration of simulation. Together with pre-calculated per segment k-spaces, this can reduce the signal equation from a sum over all voxels to a computationally cheap, resolution independent signal calculation.

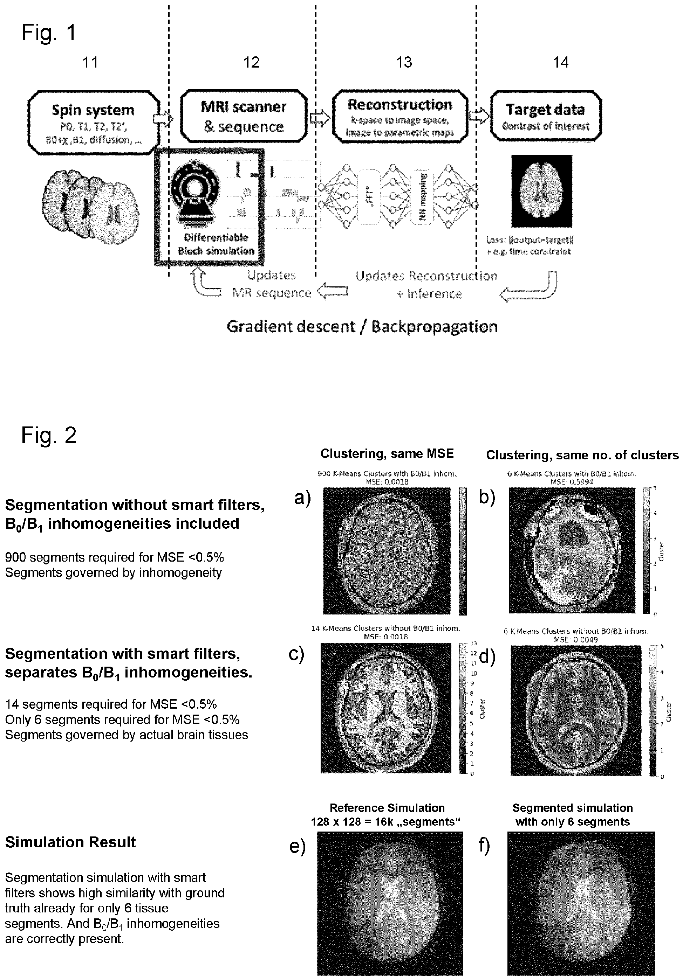

The general procedure is given in Fig. 1, which illustrates an optimization framework according to invention based on a Bloch simulation. Reference numeral 11 illustrates the provision of a parameter set to be processed by the Bloch-simulation for an object to be simulated (such as tissue of a human being). The parameter set corresponds to the defined "Spin System". The parameter set comprises, for example, at least one of 3D parameter maps of proton density (PD), $T_1$, $T_2$, and $T_2'$ relaxation times, field inhomogeneity maps of $B_0$ and $B_1$, and isotropic or anisotropic diffusion parametrization. Further parameters may be considered in the parameter set. Reference numeral 12 represents conducting an MRI simulation by executing the differentiable Bloch-simulation using the provided parameter set in order to calculate a signal response of MR sequences ("MRI scanner & sequence"). The MR sequences are of sequential, thus a signal and a magnetization state at any time depends in principle on the full magnetization and sequence history. Conducting the MRI simulation consists of processing a description of Bloch-equations in the Fourier domain, where phase distribution graphs, PDGs, describing a magnetization at any point during an MR sequence are processed. This may be done by splitting it into a variable number of states, each representing a part of the magnetization with arbitrary gradient and time dephasing thereby encoding all parts of the magnetization, describing complete echo shapes, while being fully differentiable in time, gradients and RF pulse flip angle and phase, allowing for efficient sequence optimization. Reference numeral 13 ("Reconstruction") represents processing the signal response to provide reconstruction information. The reconstruction comprises mapping of k-space to image space as well as mapping of the image to parametric maps. Reference numeral 12 represents derivation of target data ("Target data") from the reconstruction information, the target data comprising a contrast information. In order to improve the simulation, a backpropagation to conducting the MRI simulation, 12, is made, thereby providing updated information about reconstruction and inference to update the MR sequence.

The below described method adapts conducting the MRI simulation in 12. In PDG, the amplitude / occupation of individual states $F_{k,\tau}$, as well as their dephasing $k, \tau$ is tracked for all simulated voxels $v$. The exact workings are described in reference [1]. The magnetization of a spin at position $r$ with a Larmor frequency of $\omega$ is described by those states as follows:

$$M^{\hat{e}}(r, \omega) = \sum_v \sum_{k,\tau} \left(F_{k,\tau}^{\hat{e}}\right)_v \cdot e^{ikr} \cdot e^{i\tau\omega} \cdot W_v(\omega) \cdot V_v(r) \quad (1)$$

It is described as the sum of all voxels $v$, typically in the range of 10.000 - 100.000. $(F_{k,\tau})_v$ is a complex scalar, $V_v(r)$ a real valued function describing the magnetization density inside a voxel, $W_v(\omega)$ describes the off-resonance distribution of Larmor frequencies. The phase produced by gradient encoding and off-resonance dephasing is given by the two exponential terms. The equation for the signal $S^+$ can be derived by integrating of the transversal (+) magnetization over space and frequency spectrum. With sinc-shaped voxels and a Cauchy off-resonance distribution it yields:

$$S^+ = \sum_v \sum_{k,\tau} \left(F_{k,\tau}^+\right)_v \cdot \left(e^{i\Delta\omega_0\tau} \cdot e^{-|\tau|/T_2'}\right) \cdot \left(e^{ikr_v} \cdot \Theta(k - k_v)\right) \quad (2)$$

Typically, voxels $v$ are thought of discrete, uniformly spaced samples of a continuous, three-dimensional field. The novel change in segmented PDG is to deviate from this notation and to use the density of a tissue directly as the distribution $V(r)$ (see equation (2)). With this change, we can replace the gradient dephasing $e^{ikr_v}$ over all voxels v with the lookup of a pre-computed k-space (Fourier Transformation) of the tissue density function $\tilde{V}(k)$ in the signal equation (2), reducing the computational effort from 10.000 - 100.000 voxels to 1 - 100 tissues, accelerating computation by a factor of up to 1000.

$$S^+ = \sum_s \sum_{k,\tau} \left(F_{k,\tau}^+\right)_s \cdot \left(e^{i\Delta\omega_0\tau} \cdot e^{-|\tau|/T_2'}\right) \cdot \tilde{V}(k) \quad (3)$$

The first contribution of segmented PDG is this replacement of individual voxels v with segments s (tissues) that have arbitrary shapes. It is accompanied by a second contribution: Combining this segmentation magnetic field inhomogeneities, which do not follow this segmentation. In equation (3), $F_{k,\tau}$ and $\Delta\omega_0$ are assumed to be scalars, which means they do not vary spatially. In PDG, $T_1$ and $T_2$ relaxation as well as diffusion will affect the state amplitude $F_{k,\tau}$, as does the amplitude of the RF-field $B_1$.

While for the former, it can be assumed that they are constant within a segment $s$ (as the segmentation works on areas of identical physical properties), this is not true for the latter.

In segmented PDG, we still have a spatially resolved $\left(F_{k,\tau}^+\right)_{s,v}$ and $(\Delta\omega_0)_v$ that is then combined with the pre-computed k-space of a segment. Because inhomogeneities in the RF-field as well as the main magnetic field are very low-frequency in nature, a much lower resolution can be used, while the resolution of the segment k-space $\tilde{V}(k)$ is arbitrarily high without any increase in computational effort. Combining the simulated, spatially resolved tensors $\left(F_{k,\tau}^+\right)_{s,v}$ and $(\Delta\omega_0)_v$ with the pre-computed k-space replaces the integral over space with a folding operation in k-space:

$$S^+ = \sum_s \sum_{k,\tau} e^{-|\tau|/T_2'} \cdot \left(\mathcal{F}_v\left[\left(F_{k,\tau}^+\right)_{s,v} \cdot e^{i(\Delta\omega_0)_v\tau}\right] * \tilde{V}\right)(k) \quad (4)$$

$\mathcal{F}_x [f(x)](y)$ denotes the Fourier Transformation of $f(x)$ over parameter $x$, evaluated at $y$.

For a spatial resolution of $n$ for the magnetic field inhomogeneities and $N$ for the segmentation, the computational cost is $\mathcal{O}(n \cdot \log n)$ for the Fourier Transformation using the Fast Fourier Transformation algorithm, and $\mathcal{O}(n)$ for the fold evaluated at a single point.

The cost of the non-segmented PDG simulation is $\mathcal{O}(N)$, which means that segmentation is faster as long as $n \cdot \log n < N$, which is the case when using a high resolution $N$ for the segmentation and low resolution $n$ for the magnetic field inhomogeneities.

Example segmentations, and proof of this concept is shown in Fig. 2. Figs. 2a), 2b) show how a brain tissue property map can be separated in similar segments when inhomogeneities are present: many segments are still needed for good accuracy (MSE with regard to the segments properties compared to the group average). When $B_0$ and $B_1$ inhomogeneities are applied as a filter (Figs. 2c), 2d)), the segmentation is mainly based on tissue parameters $T_1$ and $T_2$ and decays very well into segments with a much smaller MSE for a low number of segments. The simulation result of the PDG with segmentation simulation with smart filters (Figs. 2e), 2f)) shows high similarity with the ground truth for only 6 tissue segments (Fig. 2f)), still accurately depicting the $B_0/B_1$ inhomogeneities, lowering the computational load from the number of voxels, to number of segments.

2. Temporal segmentation with smart overlap.

Another specific problem of simulation MR sequences is the length of sequences, the resulting growth of the phase distribution graphs, and vanishing gradients. MR sequences as such are of sequential nature, thus the signal and the magnetization state at any time depends in principle on the full magnetization and sequence history. This is why it is often assumed that general temporal parallelization of MR sequences is impossible, with general we mean also in fully transient sequences like MR fingerprinting.

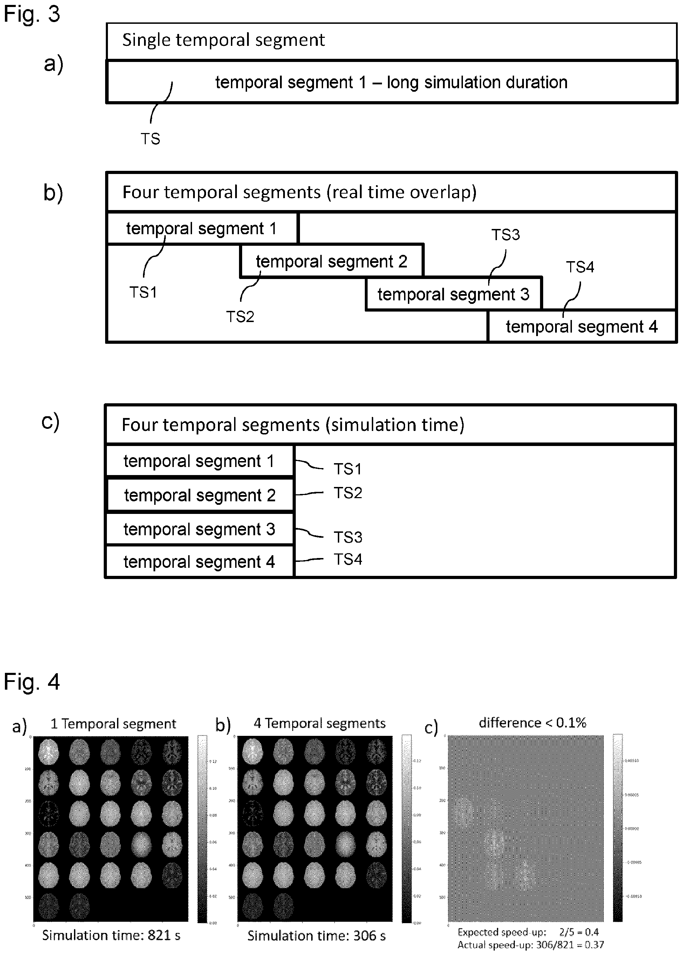

However, this is not fully true, as information in the Bloch system ultimately decays with the $T_1$ and $T_2$ relaxation, with $T_1$ being typically the slowest process with values up to 4s in liquids. This means that any magnetization history decays by exp(-t/$T_1$), which means the information is typically decayed after 3-5 $T_1$. Thus, any sequence that is much longer than $T_1$, can be divided into temporal segments of a very specific structure as depicted in Figure 3a). Fig. 3a) - c) illustrate the principal procedure of a temporal segmentation of a sequential computation of MR sequences.

Fig. 3a) shows a single temporal segment TS as would be the result of conventional simulation. Instead of a single temporal segment, the MR sequence is divided in multiple subsegments TS1, ..., TS4. In the present example, four (4) subsegments are illustrated by way of example. The number of subsegments can be chosen differently.

Each of the subsegments TS1, ..., TS4 has a duration of larger than 5 x $T_1$, overlapping at the last 5 x $T_1$ as depicted in Fig. 3b). In the present example, the overlap of two adjacent subsegments corresponds to 5 x $T_1$ (i.e., identical) by way of example. It is to be noted, that the overlap between adjacent two subsegments may be chosen variable.

The benefit of this procedure is that the temporal segments TS1, ..., TS4 are now independent and can be simulated in parallel (as shown in Fig. 3c)), which breaks up the major drawback of sequential MRI simulation. Most interestingly the simulation time of the temporal segment approach, if fully parallelized stays at exactly the simulation time of one segment, independent of the full length of the original sequence. With clinical sequence lengths of several minutes this leads to another order of magnitude in acceleration. The size of the subsegments can be adjusted to memory and run time specifications. Proof of this concept is shown in Fig. 4.

Fig. 4 shows a first multi contrast MR sequence resulting from one (1) temporal segment having a simulation time of 821 seconds (Fig. 4a)), a second multi contrast MR sequence resulting from four (4) temporal segments run in parallel having a simulation time of 306 seconds (Fig. 4b)), and the difference between the first and the second image (Fig. 4c)). The expected reduction is by 0.4 or an acceleration factor of 2.5. The acceleration factor will grow with the length of the sequence. Thus, this speed-up strategy scales over-proportionally with resolution, coverage and number of contrasts.

3. Steady-state assumptions for steady-state sequences.

In some MR sequences, certain magnetization states are driven into a steady state. This means that the magnetization state after a repetition is identical to the state before that repetition. In the pre-pass such steady-states can be detected, and the same state can be reused during the steady-state phase, instead of calculating every steady-state as transient state. This drastically reduces the number of states during graph execution and lowers the computational demand. Importantly, with phase distribution graphs the splitting of magnetization allows to avoid unnecessary re-computation of any state that was previously encountered in the sequence, even if the total magnetization is not in steady-state.

4. Distributed computing of spatial and temporal segments.

The methods according to 1. to 3. as described above may be combined or superimposed. The method may be executed on one or more distributed CPUs, GPUs, or TPUs.

5. PDG trained neural network or transformer model, or PDG-accuracy-enhancement network

To solve the problem of fastest simulation, neural network approaches can be used. The previous steps allow to generate very large dictionaries, which can then be again used to train neural networks (NNs). The well-known transformer architecture can use attention layers to effectively change upon its input, thus it can learn general physics concepts allowing generalization to the MR imaging process, which is a combination of underlying in silico MR object parameters, and the sequence parameters. Most similar concept is a vision transformer for image generation, or prompt-based image alteration. MR parameters form the multi-channel input image, the MR sequence forms the prompt, and the output is the MR image. Moreover, input data can in addition to the MR parameters also be at least one low accuracy or low resolution fast PDG simulation output, thus the NN task is accuracy enhancement.

A PDG NN/Transformer Model that is trained with a large dictionary of 3D simulation data for many different objects and many different sequences can be used as a full simulation surrogate, with another speed gain. Moreover, it can also be trained and used as a backwards model providing starting point for optimization and iterative reconstruction.

6. Improved Bloch-Model-based variational network.

Iterative Optimization processes can also be unrolled as shown for variational networks. An improved Bloch-Model-based variational Network is proposed, which consists of network layers estimating MR parameters, and data consistency checks between layers using the accelerated forward simulation only presented above in points 1.-6. By only relying on the forward simulation, orders of magnitude of simulation speed are won. It is still possible to solve inverse optimization problems. A similar unrolled network can be used for sequence parameter optimization.

By having the correct forward model, both 6. and 7. can always be extended by a physics-informed data consistency, avoiding generative components in predictions and simulations.

The mentioned methods can be combined for different purposes. Methods 1.-4. already enable acceleration factors in computation from 10.000 to 100.000 and thus are a very fast MR simulation that enables efficient physics-informed MR sequence optimization and parameter reconstruction. Methods 5.-7. will further accelerate inference but requires training.

The accelerated simulation is part of an optimization framework depicted in Fig. 1. The objective function can be written as

$$\Phi^*, \Psi^*, \Theta^* = \underset{\Phi, \Psi, \Theta}{argmin} \left( \sum_i \left\| T_i - NN_\Theta \left( RECO_\Phi \left( SCAN_\Psi(M_i) \right) \right) \right\|_p + \lambda R(\Phi, \Psi, \Theta) \right)$$

where SCAN reflects the differentiable improved Bloch simulation using the magnetization properties M, the target image T, for optimizing the MR sequence parameters $\Psi$, MR tissue parameters Mi, or concatenated recon ($\phi$) or neural network parameters $\theta$ for end-to-end optimization.

References

1. Endres J, Weinmüller S, Dang HN, Zaiss M. Phase distribution graphs for fast, differentiable, and spatially encoded Bloch simulations of arbitrary MRI sequences. Magnetic Resonance in Medicine. Published online 2023. doi: 10.1002/mrm.30055

2. Weigel M. Extended phase graphs: dephasing, RF pulses, and echoes - pure and simple. J Magn Reson Imaging. 2015;41(2):266-295. doi: 10.1002/jmri.24619

3. Liu H, van der Heide O, van den Berg CAT, Sbrizzi A. Fast and accurate modeling of transient-state, gradient-spoiled sequences by recurrent neural networks. NMR Biomed. 2021;34(7):e4527. doi:10.1002/nbm.4527

4. Stöcker T, Vahedipour K, Pflugfelder D, Shah NJ. High-performance computing MRI simulations. Magnetic Resonance in Medicine. 2010;64(1): 186-193. doi:https://doi.org/10.1002/mrm.22406

5. van der Heide O, van den Berg CAT, Sbrizzi A. GPU-accelerated Bloch simulations and MR-STAT reconstructions using the Julia programming language. Magnetic Resonance in Medicine. 2024;92(2):618-630. doi:

10.1002/mrm.30074

## Claims

1. A method for computer-implemented processing of MR sequences based on a Bloch-simulation, comprising the steps of:

   a) providing a parameter set to be processed by the Bloch-simulation for an object to be simulated, where the parameter set comprises at least one of 3D parameter maps of proton density (PD), $T_1$, $T_2$, and $T_2'$ relaxation times, field inhomogeneity maps of $B_0$ and $B_1$, and isotropic or anisotropic diffusion parametrization;
   b) conducting an MRI simulation by executing the Bloch-simulation using the provided parameter set in order to calculate a signal response of MR sequences, where conducting the MRI simulation consists of processing a description of Bloch-equations in the Fourier domain, where phase distribution graphs, PDGs, describing a magnetization at any point during an MR sequence are processed;
   c) processing the signal response to provide reconstruction information; and
   d) deriving target data from the reconstruction information, the target data comprising a contrast information;

   wherein calculating the signal response ($S^+$) comprises integrating of the transversal (+) magnetization over space and frequency spectrum, and
   wherein the magnetization of a spin at a position r with a Larmor frequency of $\omega$ is determined for all simulated voxels $v$ by directly using the density of a tissue as a distribution $V(r)$ describing the magnetization density inside a voxel segment.

2. The method according to claim 1, wherein the signal response ($S^+$) is calculated by

$$S^+ = \sum_s \sum_{k,\tau} \left(F_{k,\tau}^+\right)_s \cdot \left(e^{i\Delta\omega_0\tau} \cdot e^{-|\tau|/T_2'}\right) \cdot \tilde{V}(k)$$

   wherein

   $s$ is a voxel segment representing tissue,
   $k$ is the modulation from $B_0$ field gradients,
   $\tau$ describes the width of the phase distribution as a result of off-resonance;
   $F_{k,\tau}$ denotes a state amplitude;
   $\Delta\omega_0$ is a center frequency of a Cauchy function;
   $T_2'$ denotes spatially varying dephasing; and
   $\tilde{V}(k)$ denotes a lookup of a pre-computed k-space (Fourier Transformation) of a tissue density function.

3. The method according to claim 1 or 2, wherein a respective voxel segment is of an arbitrary shape.

4. The method according to claim 2 or 3, wherein the state amplitude, $F_{k,\tau}$, and the center frequency, $\Delta\omega_0$, are assumed to be scalars, where $T_1$ and $T_2$ relaxations as well as diffusion affects the state amplitude, $F_{k,\tau}$, as does the amplitude of the RF-field $B_1$.

5. The method according to one of the preceding claims 2 to 4, wherein spatially resolved tensors $\left(F_{k,\tau}^+\right)_{s,v}$ and $(\Delta\omega_0)_v$ are combined with the pre-computed k-space, replacing the integral over space with a folding operation in k-space according to:

$$S^+ = \sum_s \sum_{k,\tau} e^{-|\tau|/T_2'} \cdot \left(\mathcal{F}_v\left[\left(F_{k,\tau}^+\right)_{s,v} \cdot e^{i(\Delta\omega_0)_v\tau}\right] * \tilde{V}\right)(k)$$

   wherein $[f(x)](y)$ denotes the Fourier Transformation of $f(x)$ over parameter $x$, evaluated at $y$.

6. The method according to one of the preceding claims, wherein the MR sequence which is the input for the Bloch-simulation, is divided into a plurality of subsegments, each subsegment having a duration of larger than N-times of $T_1$ relaxation and containing sequential MR sequences, where the subsegments within the total number of MR sequences are chosen such that each adjacent two subsegments overlap the last N-times of $T_1$ relaxation.

7. The method according to claim 6, wherein the subsegments are processed by the Bloch-simulation in parallel.

8. The method according to claim 6 or 7, wherein the overlap between adjacent two subsegments is chosen identical or variable.

9. The method according to one of claims 6 to 8, wherein the subsegments have the same number of MR sequences or at least some of the subsegments have a different number of MR sequences.

10. The method according to one of the preceding claims, wherein a two-pass simulation approach is used in which a first pre-pass of the simulation uses a fast, single voxel approximation of the magnetization and in which determined steady-states are reused during the steady-state phase.

11. A computer program product comprising instructions which, when the program is executed by a computer, cause the computer to carry out the steps of the method of one of the preceding claims.

12. A data processing apparatus comprising means for carrying out the steps of the method of one of the preceding claims.

# Fig. 1

# Fig. 2

## Fig. 3

a)

| Single temporal segment |
|---|
| temporal segment 1 – long simulation duration |

TS

b)

| Four temporal segments (real time overlap) |
|---|

temporal segment 1

TS3

TS1

temporal segment 2

TS4

TS2

temporal segment 3

temporal segment 4

c)

| Four temporal segments (simulation time) | |
|---|---|
| temporal segment 1 | TS1 |
| temporal segment 2 | TS2 |
| temporal segment 3 | TS3 |
| temporal segment 4 | TS4 |

## Fig. 4

a) 1 Temporal segment
b) 4 Temporal segments
c) difference < 0.1%

Simulation time: 821 s

Simulation time: 306 s

Expected speed-up: 2/5 = 0.4
Actual speed-up: 306/821 = 0.37

| Europäisches Patentamt / European Patent Office / Office européen des brevets | **EUROPEAN SEARCH REPORT** | **Application Number** EP 24 21 8587 |
|---|---|---|

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | JONATHAN ENDRES ET AL: "Phase distribution graphs for fast, differentiable, and spatially encoded Bloch simulations of arbitrary MRI sequences", MAGNETIC RESONANCE IN MEDICINE, WILEY-LISS, US, vol. 92, no. 3, 4 April 2024 (2024-04-04), pages 1189-1204, XP072655308, ISSN: 0740-3194, DOI: 10.1002/MRM.30055 * page 1190, column 2, paragraph 4 - page 1200, column 2, paragraph 1; figures 2, 8 * | 1-12 | INV. G01R33/54 G06T11/00 |
| | ----- | | |
| | | | TECHNICAL FIELDS SEARCHED (IPC) G01R G06T |

The present search report has been drawn up for all claims

| Place of search | Date of completion of the search | Examiner |
|---|---|---|
| Munich | 16 May 2025 | Raguin, Guy |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **ENDRES J ; WEINMÜLLER S ; DANG HN ; ZAISS M**. Phase distribution graphs for fast, differentiable, and spatially encoded Bloch simulations of arbitrary MRI sequences. *Magnetic Resonance in Medicine.*, 2023
- **WEIGEL M.** Extended phase graphs: dephasing, RF pulses, and echoes - pure and simple.. *J Magn Reson Imaging.*, 2015, vol. 41 (2), 266-295
- **LIU H ; VAN DER HEIDE O ; VAN DEN BERG CAT ; SBRIZZI A**. Fast and accurate modeling of transient-state, gradient-spoiled sequences by recurrent neural networks. *NMR Biomed.*, 2021, vol. 34 (7), e4527
- **STÖCKER T ; VAHEDIPOUR K ; PFLUGFELDER D ; SHAH NJ**. High-performance computing MRI simulations. *Magnetic Resonance in Medicine.*, 2010, vol. 64 (1), 186-193
- **VAN DER HEIDE O ; VAN DEN BERG CAT ; SBRIZZI A**. GPU-accelerated Bloch simulations and MR-STAT reconstructions using the Julia programming language. *Magnetic Resonance in Medicine.*, 2024, vol. 92 (2), 618-630